# EUROPEAN PATENT SPECIFICATION

(11) **EP 4 651 141 B1**
(45) Date of publication and mention of the grant of the patent: **11.11.2026**
(21) Application number: 24212400.6
(22) Date of filing: 12.11.2024
(51) Int. Cl.: G11C 29/02

(54) **STORAGE CONTROLLER, STORAGE DEVICE INCLUDING THE SAME AND OPERATING METHOD THEREOF**
SPEICHERSTEUERUNG, SPEICHERVORRICHTUNG DAMIT UND BETRIEBSVERFAHREN DAFÜR
CONTRÔLEUR DE STOCKAGE, DISPOSITIF DE STOCKAGE LE COMPRENANT ET SON PROCÉDÉ DE FONCTIONNEMENT

(30) Priority: 16.05.2024 KR 20240063811
(43) Date of publication of application: 19.11.2025
(73) Proprietor: Samsung Electronics Co., Ltd., Suwon-si, Gyeonggi-do 16677 (KR)
(72) Inventor: KIM, Myungkyu, 16677 Suwon-si (KR); SEOK, Junyeong, 16677 Suwon-si (KR); KIM, Minoh, 16677 Suwon-si (KR); PARK, Jungho, 16677 Suwon-si (KR); SHIN, Beomkyu, 16677 Suwon-si (KR)
(74) Representative: Marks & Clerk LLP

(56) References cited:
- US-A1- 2007 027 650
- US-A1- 2019 050 022
- US-A1- 2022 332 330

## Description

### BACKGROUND

Devices and apparatuses consistent with the present disclosure relate to a storage controller, a storage device including the same, and an operating method thereof and, more specifically, to a storage controller that performs a read training operation based on at least a part of user data, a storage device including the same, and an operating method thereof.

A semiconductor memory is classified into a volatile memory device such as a static RAM (SRAM), a dynamic RAM (DRAM), a synchronous DRAM (SDRAM), etc. in which stored data is destroyed when power supply to the semiconductor memory is cut off, and a non-volatile memory device such as a read only memory (ROM), a programmable ROM (PROM), an electrically programmable ROM(EPROM), an electrically erasable and programmable ROM (EEPROM), a flash memory device, a phase-change RAM (PRAM), a magnetic RAM (MRAM), a resistive RAM (RRAM), a ferroelectric RAM (FRAM), etc. in which stored data is maintained even when power supply to the semiconductor memory is cut off.

The non-volatile memory devices such as flash memory devices are widely used as mass storage media in computing systems. The flash memory device is configured to communicate with the memory controller based on electrical signals. Electrical signals can be distorted due to various factors that occur during the operation of the flash memory device, resulting in the flash memory device not able to transmit and receive data normally.

US 2019/050022 A1 describes interface adjustment processes for a data storage device.

US 2007/027650 A1 describes methods and apparatus for memory calibration.

US 2022/332330 A1 describes vehicles comprising a host device and memory device.

### SUMMARY

The invention provides a storage device and method for operating a storage device as set out in the accompanying claims.

### BRIEF DESCRIPTION OF THE DRAWINGS

FIG. 1 is a block diagram illustrating a storage system according to some embodiments;
FIG. 2 is a block diagram illustrating the storage device according to some embodiments;
FIG. 3 is a block diagram illustrating the storage device according to some embodiments;
FIG. 4 is a block diagram illustrating an example of a detailed configuration of the storage controller and the non-volatile memory device for performing the read training operation, according to some embodiments;
FIG. 5 is a flowchart illustrating an example in which a read training operation is performed, according to some embodiments;
FIG. 6 is a flowchart illustrating another example in which the read training operation is performed, according to some embodiments;
FIGS. 7 to 9 are diagrams illustrating various examples of data signals DQ transmitted and received in connection with the read training operation, according to some embodiments;
FIG. 10 is a block diagram illustrating, in more detail, an example of a configuration of the storage controller for performing the read training operation, according to some embodiments;
FIGS. 11 to 13 are diagrams illustrating various examples in which the read training operation is performed using the storage controller and the non-volatile memory device of FIG. 10, according to some embodiments;
FIG. 14 is a block diagram illustrating an example of the training circuit including a pattern generator, according to some embodiments;
FIG. 15 is a block diagram illustrating an example in which a training pattern adjusted in length is generated using the pattern generator, according to some embodiments;
FIG. 16 is a block diagram illustrating an example in which a plurality of training patterns are generated using the pattern generator, according to some embodiments;
FIG. 17 is a flowchart illustrating an example in which a plurality of read training operations are performed using the pattern generator of FIG. 16, according to some embodiments;
FIG. 18 is a block diagram illustrating a storage device including a frequency boosting interface (FBI) chip, according to some embodiments; and
FIG. 19 is a flowchart illustrating an operating method of a storage device, according to some embodiments.

### DETAILED DESCRIPTION

According to various aspects of the present disclosure, read training may be performed without a data-in operation of the data separately generated for the read training operation, thereby shortening time required for read training. According to various aspects of the present disclosure, the read training operation may be performed even during runtime of the non-volatile memory device.

According to various aspects of the present disclosure, the program data-in command and the read training command may be transmitted to the non-volatile memory device as one command such that a time for the read training operation can be further shortened compared to when the read training command and the program data-in command are transmitted separately as a separate commands to the non-volatile memory device.

The advantages described above that can be obtained through various embodiments of the present disclosure are not limited to those described above and various technical advantages not mentioned will be clearly understood by those skilled in the art from the description that follows.

As used in this specification, , a phrase using the form "at least one of A, B, or C" includes within its scope "only A", "only B", "only C", "A and B", "A and C", "B and C" and "A, B, and C."

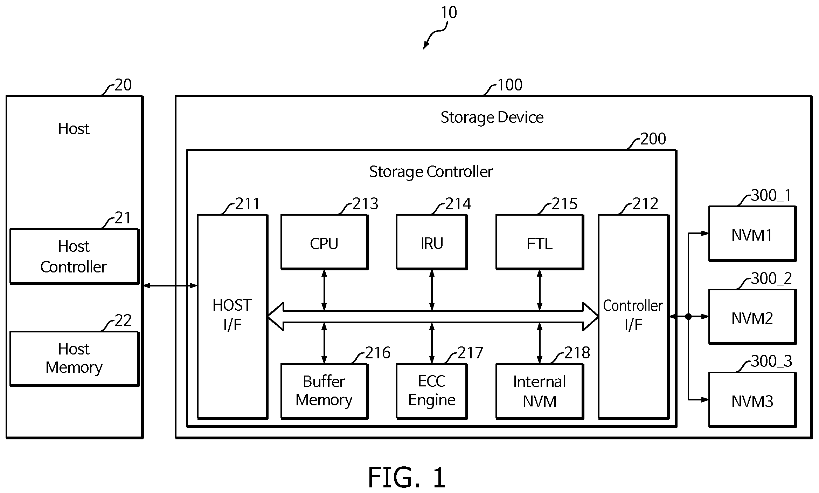

Hereinafter, various embodiments will be described with reference to FIGS. 1 to 19. The same reference numerals may refer to the same components throughout the description and repeated description thereof may be omitted for conciseness.

FIG. 1 is a block diagram illustrating a storage system 10 according to some embodiments. Referring to FIG. 1, the storage system 10 may include a host 20 and a storage device 100. In some embodiments, the storage device 100 may include a storage controller 200 and a plurality of non-volatile memory (NVM) devices 300_1 to 300_3. In some embodiments, in some aspects, the host 20 may include a host controller 21 and a host memory 22. The host memory 22 may serve as a buffer memory for temporarily storing data to be transmitted to the storage device 100 or data received from the storage device 100. While three NVM devices 300_1 to 300_3 are illustrated in the example of FIG. 1, this is only an example and, in some embodiments, the number of NVM devices 300 may be greater than or less than three.

The storage device 100 may include a storage medium for storing data according to a request from the host 20. For example, the storage device 100 may be implemented as at least one of a solid state drive (SSD), an embedded memory, or a removable external memory. If the storage device 100 is an SSD, the storage device 100 may be a device conforming to the non-volatile memory express (NVMe) standard. If the storage device 100 is an embedded memory or external memory, the storage device 100 may be a device conforming to the universal flash storage (UFS) or embedded multi-media card (eMMC) standard. The host 20 and the storage device 100 may generate packets according to an adopted standard protocol adopted by the host 20 and/or the storage device 100 and transmit the generated packets.

In some embodiments, if the non-volatile memory devices 300_1 to 300_3 are implemented as a flash memory, the flash memory may include a 2D NAND memory array or a 3D (or vertical, or bonding-vertical) NAND (VNAND) memory array. In some embodiments, the storage device 100 may include various other types of non-volatile memories and/or volatile memories. For example, the storage device 100 may include at least one of volatile or non-volatile memories such as static RAM (SRAM), dynamic RAM (DRAM), synchronous DRAM (SDRAM), read only memory (ROM), programmable ROM (PROM), electrically programmable ROM (EPROM), electrically erasable and programmable ROM (EEPROM), magnetic RAM (MRAM), spin-transfer torque MRAM, conductive bridging RAM (CBRAM), ferroelectric RAM (FeRAM), phase RAM (PRAM), resistive RAM, etc.

In some embodiments, the host controller 21 and the host memory 22 may be implemented as separate semiconductor chips. In some embodiments, the host controller 21 and host memory 22 may be integrated on the same semiconductor chip. For example, the host controller 21 may be any one of a plurality of modules provided in an application processor, and the application processor may be implemented as a System on Chip (SoC). In some embodiments, the host memory 22 may be an embedded memory provided in the application processor, or may be a volatile memory or memory module provided outside the application processor.

The host controller 21 may manage the operation of storing data (e.g., write data) from the host memory 22 to the non-volatile memory devices 300_1 to 300_3, or storing data (e.g., read data) from the non-volatile memory device 300 to the host memory 22. For example, the host controller 21 may manage the operation of storing user data associated with the execution of a specific program in the non-volatile memory devices 300_1 to 300_3.

The storage controller 200 may include a host interface (I/F) 211, a controller interface (I/F) 212, and a central processing unit (CPU) 213. In some embodiments, the storage controller 200 may further include an index read unit (IRU) 214, a flash translation layer (FTL) 215, a buffer memory 216, an error correction code (ECC) engine 217, and an internal non-volatile memory (NVM) 218. In some embodiments, the storage controller 200 may further include a working memory loaded with the flash translation layer 215, and data writing operations and/or reading operations with respect to the non-volatile memory may be controlled by the CPU 213 executing the flash translation layer 215. For example, the operation of writing the user data for the non-volatile memory devices 300_1 to 300_3 may be controlled by the CPU 213 executing the flash translation layer 215.

The host interface (I/F) 211 may transmit and receive packets to and from the host 20. The packets transmitted from the host 20 to the host interface 211 may include a command and/or data (e.g., user data), etc. to be written to the non-volatile memory devices 300_1 to 300_3, and the packets transmitted from the host interface 211 to the host 20 may include a response to command, or data read from the non-volatile memory devices 300_1 to 300_3, etc. In FIG. 1, the host interface 211 is illustrated as being included in the storage controller 200, but embodiments are not limited thereto. For example, in some embodiments, the host interface 211 may be located outside the storage controller 200.

The controller interface (I/F) 212 may transmit data (e.g., user data) to be written to the non-volatile memory devices 300_1 to 300_3 to the non-volatile memory devices 300_1 to 300_3, or may receive read data (e.g., user data) from the non-volatile memory devices 300_1 to 300_3. The controller interface 212 may be implemented to comply with standard protocols such as Toggle or the Open NAND Flash Interface (ONFI).

The flash translation layer (FTL) 215 may perform several functions such as address mapping, wear-leveling, and/or garbage collection. In some embodiments, the buffer memory 216 may temporarily store data to be written to non-volatile memory devices 300 or data read from the non-volatile memory devices 300_1 to 300_3. The buffer memory 216 may be a component provided within the storage controller 200, but this is only an example and, in some embodiments, the buffer memory 216 may be provided outside the storage controller 200.

The error correction code (ECC) engine 217 may perform an error detection and correction function on read data read from the non-volatile memory devices 300_1 to 300_3. More specifically, the ECC engine 217 may generate a parity bit for write data to be written to the non-volatile memory devices 300_1 to 300_3, and the generated parity bit may be stored in the non-volatile memory devices 300_1 to 300_3 together with the write data. When reading data from the non-volatile memory devices 300_1 to 300_3, the ECC engine 217 may use the parity bit read from the non-volatile memory devices 300_1 to 300_3 together with the read data to correct errors in the read data, and output the error-corrected read data. The index read unit (IRU) 214 may process and reorder indices used to perform irregular memory accesses to improve memory coalescing.

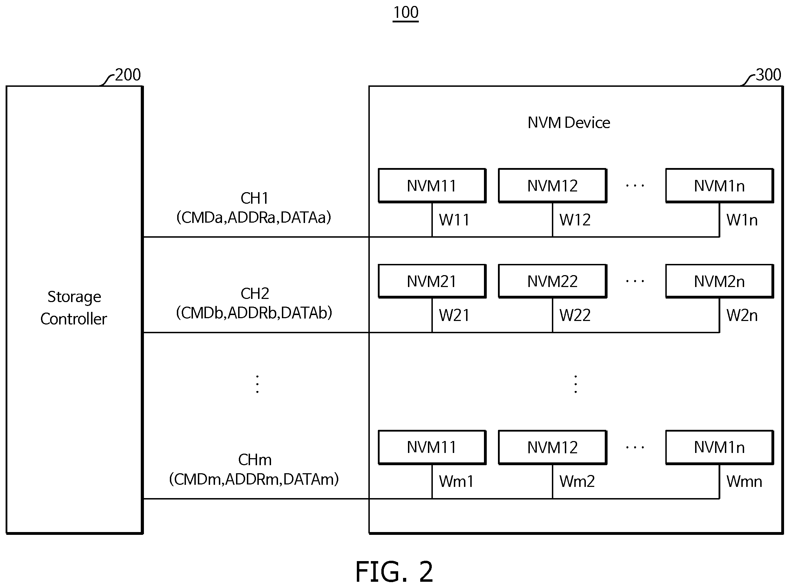

FIG. 2 is a block diagram illustrating the storage device 100 according to some embodiments.

Referring to FIG. 2, the non-volatile memory device 300 and the storage controller 200 may be connected to each other through a plurality of channels CH1 to CHm.

The non-volatile memory device 300 may include a plurality of non-volatile memory devices NVM11 to NVMmn. Here, m and n may each be integers. The plurality of non-volatile memory devices NVM11 to NVMmn may correspond to the plurality of non-volatile memory devices 300_1 to 300_3 of FIG. 1.

Each of the non-volatile memory devices NVM11 to NVMmn may be connected to one of the plurality of channels CH1 to CHm through a corresponding way. Each of the non-volatile memory devices NVM11 to NVMmn may be implemented in any units of memories that may operate according to an individual command from the storage controller 200. For example, each of the non-volatile memory devices NVM11 to NVMmn may be implemented as a chip or die, but embodiments are not limited thereto.

The storage controller 200 may transmit and receive a data signal to and from the non-volatile memory device 300 through the plurality of channels CH1 to CHm. For example, the storage controller 200 may transmit commands CMDa to CMDm, addresses ADDRa to ADDRm, and data DATAa to DATAm to the non-volatile memory device 300 through the channels CH1 to CHm, or may receive data DATAa to DATAm from the non-volatile memory device 300.

The storage controller 200 may select one of the non-volatile memory devices 300 connected to the corresponding channel through each channel, and transmit and receive signals to and from the selected non-volatile memory device.

The storage controller 200 may transmit and receive signals to and from the non-volatile memory device 300 in parallel through different channels. For example, the storage controller 200 may transmit the command CMDb to the memory device NVM21 through the second channel CH2, while transmitting the command CMDa to the memory device NVM11 through the first channel CH1. For example, the storage controller 200 may receive the data DATAb from the memory device NVM21 through the second channel CH2, while receiving the data DATAa from the memory device NVM11 through the first channel CH1.

FIG. 2 illustrates that the non-volatile memory device 300 communicates with the storage controller 200 through m channels and that the non-volatile memory device 300 includes n non-volatile memory devices corresponding to each channel, but embodiments are not limited thereto and, in some embodiments, the number of channels and the number of non-volatile memory devices connected to one channel may be variously changed.

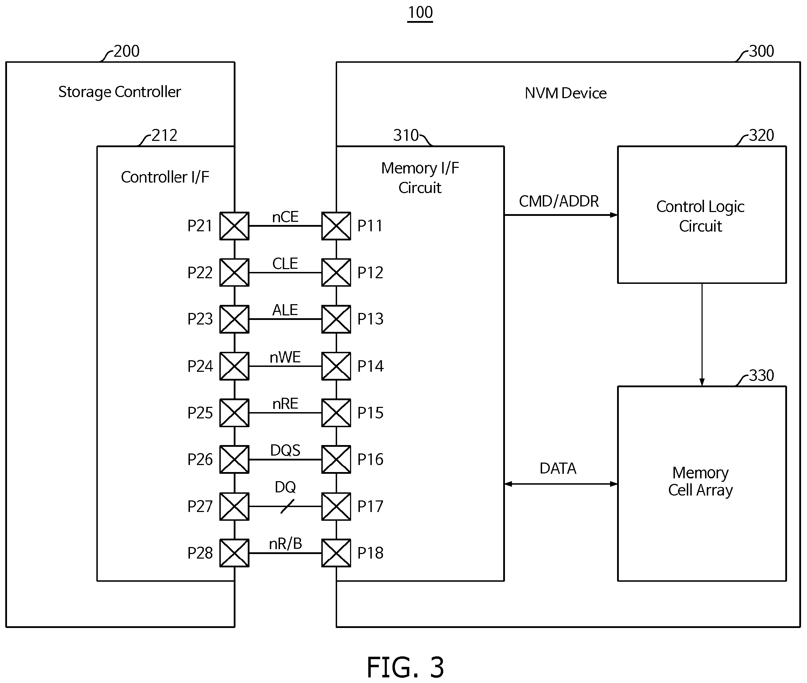

FIG. 3 is a block diagram illustrating the storage device 100 according to some embodiments.

Referring to FIG. 3, the non-volatile memory device 300 may correspond to one of the non-volatile memory devices NVM11 to NVMmn that are communicating with the storage controller 200 of FIG. 2 based on one of the plurality of channels CH1 to CHm of FIG. 2.

The non-volatile memory device 300 may include first to eighth pins P11 to P18, a memory interface (I/F) circuit 310, a control logic circuit 320, and a memory cell array 330.

The memory interface (I/F) circuit 310 may receive a chip enable signal nCE from the storage controller 200 through the first pin P11. The memory interface circuit 310 may transmit and receive signals to and from the storage controller 200 through the second to eighth pins P12 to P18 according to the chip enable signal nCE. For example, if the chip enable signal nCE is in an enable state (e.g., a high level), the memory interface circuit 310 may transmit and receive signals to and from the storage controller 200 through the second to eighth pins P12 to P18.

The memory interface (I/F) circuit 310 may receive a command latch enable signal CLE, an address latch enable signal ALE, and a write enable signal nWE from the storage controller 200 through the second to fourth pins P12 to P14. The memory interface circuit 310 may receive a data signal DQ from the storage controller 200 or transmit the data signal DQ to the storage controller 200 through the seventh pin P17. The command CMD, the address ADDR, and the data DATA may be transmitted through the data signal DQ. For example, the data signal DQ may be transmitted through a plurality of data signal lines. In this case, the seventh pin P17 may include a plurality of pins corresponding to a plurality of data signals.

The memory interface (I/F) circuit 310 may acquire the command CMD from the data signal DQ received in an enable period (e.g., a high level state period) of the command latch enable signal CLE based on toggle timings of the write enable signal nWE. The memory interface circuit 310 may acquire the address ADDR from the data signal DQ received in an enable period (e.g., a high level state period) of the address latch enable signal ALE based on toggle timings of the write enable signal nWE.

The write enable signal nWE may maintain a static state (e.g., a high level or a low level) and then toggle between the high level and the low level. For example, the write enable signal nWE may toggle in a period in which the command CMD and/or the address ADDR are transmitted. Accordingly, the memory interface circuit 310 may acquire the command CMD and/or the address ADDR based on toggle timings of the write enable signal nWE.

The memory interface (I/F) circuit 310 may receive a read enable signal nRE from the storage controller 200 through the fifth pin P15. The memory interface circuit 310 may receive a data strobe signal DQS from the storage controller 200 or transmit the data strobe signal DQS to the storage controller 200 through the sixth pin P16.

In the data DATA output operation of the non-volatile memory device 300, before outputting the data DATA, the memory interface circuit 310 may receive the read enable signal nRE that toggles through the fifth pin P15. The memory interface circuit 310 may generate a data strobe signal DQS that toggles based on the toggling of the read enable signal nRE. For example, the memory interface circuit 310 may generate a data strobe signal DQS that starts toggling after a predetermined delay (e.g., tDQSRE) based on a toggling start time of the read enable signal nRE.

The memory interface (I/F) circuit 310 may transmit the data signal DQ including the data DATA based on the toggle timing of the data strobe signal DQS. Accordingly, the data DATA may be aligned with the toggle timing of the data strobe signal DQS and transmitted to the storage controller 200.

In the data DATA input operation of the non-volatile memory device 300, if the data signal DQ including the data DATA is received from the storage controller 200, the memory interface circuit 310 may receive the data strobe signal DQS that toggles with the data DATA from the storage controller 200. The memory interface circuit 310 may acquire the data DATA from the data signal DQ based on the toggle timing of the data strobe signal DQS. For example, the memory interface circuit 310 may acquire the data DATA by sampling the data signal DQ at the rising edge and falling edge of the data strobe signal DQS.

The memory interface (I/F) circuit 310 may transmit a ready/busy output signal nR/B to the storage controller 200 through the eighth pin P18. The memory interface circuit 310 may transmit state information of the non-volatile memory device 300 to the storage controller 200 through the ready/busy output signal nR/B. If the non-volatile memory device 300 is in a busy state (i.e., if internal operations of the non-volatile memory device 300 are being performed), the memory interface circuit 310 may transmit the ready/busy output signal nR/B indicating a busy state to the storage controller 200. If the non-volatile memory device 300 is in a ready state (i.e., if internal operations of the non-volatile memory device 300 are not performed or are complete), the memory interface circuit 310 may transmit the ready/busy output signal nR/B indicating a ready state to the storage controller 200. For example, the memory interface circuit 310 may transmit the ready/busy output signal (nR/B) indicating a busy state (e.g., a low level) to the storage controller 200, while the non-volatile memory device 300 is reading the data DATA from the memory cell array 330 in response to a page read command. For example, while the non-volatile memory device 300 is programming the data DATA in the memory cell array 330 in response to a program command, the memory interface circuit 310 may transmit the ready/busy output signal nR/B indicating the busy state to the storage controller 200.

The control logic circuit 320 may control various operations of the non-volatile memory device 300 as a whole. The control logic circuit 320 may receive the command/address CMD/ADDR acquired from the memory interface circuit 310. The control logic circuit 320 may generate control signals for controlling other components of the non-volatile memory device 300 according to the received command/address CMD/ADDR. For example, the control logic circuit 320 may generate various control signals for programming the data DATA in the memory cell array 330 or reading data DATA from the memory cell array 330. In another example, the control logic circuit 320 may also generate control signals for adjusting a channel potential within the memory cell array.

The memory cell array 330 may store the data DATA acquired from the memory interface circuit 310 under the control of the control logic circuit 320. The memory cell array 330 herein may output the stored data DATA to the memory interface circuit 310 under the control of the control logic circuit 320. In some embodiments, the memory cell array 330 may adjust the channel potential in the memory cell array 330 under the control of the control logic circuit 320. The data stored in the memory cell array 330 in response to the program command, etc. may be referred to as the "user data".

The memory cell array 330 may include a plurality of memory cells. For example, a plurality of memory cells may be flash memory cells. However, embodiments are not limited thereto and, in some embodiments, the memory cells may be resistive random access memory (RRAM) cells, ferroelectric random access memory (FRAM) cells, phase change random access memory (PRAM) cells, thyristor random access memory (TRAM) cells, and/or magnetic random access memory (MRAM) cells. The memory cells will be described below with reference to the examples of NAND flash memory cells.

The storage controller 200 may include first to eighth pins P21 to P28 and the controller interface (I/F) 212. In some embodiments, the first to eighth pins P21 to P28 may correspond respectively to the first to eighth pins P11 to P18 of the non-volatile memory device 300.

The controller interface (I/F) 212 may transmit the chip enable signal nCE to the non-volatile memory device 300 through the first pin P21. The controller interface 212 may transmit and receive signals to and from the non-volatile memory device 300 selected through the chip enable signal (nCE) through the second to eighth pins P22 to P28.

The controller interface (I/F) 212 may transmit the command latch enable signal CLE, the address latch enable signal ALE, and the write enable signal nWE to the non-volatile memory device 300 through the second to fourth pins P22 to P24. The controller interface 212 may transmit the data signal DQ to the non-volatile memory device 300 through the seventh pin P27, or may receive the data signal DQ from the non-volatile memory device 300.

The controller interface (I/F) 212 may transmit the data signal DQ including the command CMD or the address ADDR together with the toggling write enable signal nWE to the non-volatile memory device 300. The controller interface 212 may transmit the data signal DQ including the command CMD to the non-volatile memory device 300 in response to transmitting the command latch enable signal CLE with the enable state, and may transmit the data signal DQ including the address ADDR to the non-volatile memory device 300 in response to transmitting the address latch enable signal ALE with the enable state.

The controller interface (I/F) 212 may transmit the read enable signal nRE to the non-volatile memory device 300 through the fifth pin P25. The controller interface 212 may receive the data strobe signal DQS from the non-volatile memory device 300 through the sixth pin P26 or transmit the data strobe signal DQS to the non-volatile memory device 300.

In the data DATA output operation of the non-volatile memory device 300, the controller interface 212 may generate a toggling read enable signal nRE and transmit the read enable signal nRE to the non-volatile memory device 300. For example, the controller interface 212 may generate a read enable signal nRE that changes from a fixed state (e.g., a high level or a low level) to a toggle state before the data DATA is output. Accordingly, the data strobe signal DQS that toggles based on the read enable signal nRE may be generated in the non-volatile memory device 300. The controller interface 212 may receive the data signal DQ including the data DATA together with the toggling data strobe signal DQS from the non-volatile memory device 300. The controller interface 212 may acquire the data DATA from the data signal DQ based on the toggle timing of the data strobe signal DQS.

In the data input operation of the non-volatile memory device 300, the controller interface 212 may generate a toggling data strobe signal DQS. For example, the controller interface 212 may generate a data strobe signal DQS that changes from a fixed state (e.g., a high level or a low level) to a toggle state before transmitting the data DATA. The controller interface 212 may transmit the data signal DQ including the data DATA to the non-volatile memory device 300 based on the toggle timings of the data strobe signal DQS.

The controller interface (I/F) 212 may receive the ready/busy output signal nR/B from the non-volatile memory device 300 through the eighth pin P28. The controller interface 212 may determine the state information of the non-volatile memory device 300 based on the ready/busy output signal nR/B.

The controller interface (I/F) 212 and the memory interface (I/F) circuit 310 illustrated and described with reference to FIG. 3 are examples and embodiments are not limited thereto. For example, in some embodiments, the controller interface 212 and the memory interface circuit 310 may further include pins that transmit and receive signals different from those illustrated and described with reference to FIG. 3. In some embodiments, some of the plurality of pins P11 to P18 and P21 to P28 of the controller interface 212 and the memory interface circuit 310 may be omitted from the controller interface 212 and the memory interface circuit 310 or may be integrated with other pins.

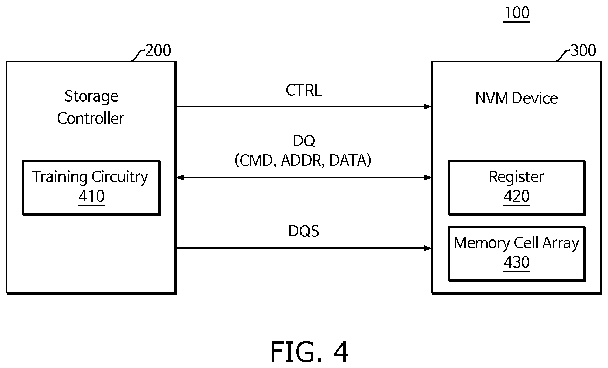

FIG. 4 is a block diagram illustrating detailed configurations of the storage controller 200 and the non-volatile memory device 300 for performing the read training operation, according to some embodiments.

Referring to FIG. 4, the storage controller 200 may transmit a control signal CTRL to the non-volatile memory device 300. For example, the control signal CTRL may include the chip enable signal nCE, the command latch enable signal CLE, the address latch enable signal ALE, the write enable signal nWE, and/or the read enable signal nRE of FIG. 3.

The storage controller 200 may transmit the command CMD, the address ADDR, and/or the data DATA to the non-volatile memory device 300 through the data signal DQ. In some embodiments, the storage controller 200 may transmit the command CMD and the address ADDR to the non-volatile memory device 300 through a separate command and address signal SCA, and transmit the data DATA to the non-volatile memory device 300 through the data signal DQ.

The non-volatile memory device 300 may identify (or capture), based on the data strobe signal DQS, the data DATA provided through the data signal DQ. The non-volatile memory device 300 may store the identified data DATA based on the received command CMD and address ADDR. The identified data DATA may include user data UD.

Hereinafter, for convenience of description, it is assumed that the "received data" in the non-volatile memory device 300 is data identified based on the data strobe signal DQS. These expressions are intended to facilitate description of various embodiments of the present disclosure and do not limit the technical idea of the present disclosure.

The non-volatile memory device 300 may store the user data UD received from the storage controller 200 in a register 420 and/or a memory cell array 430 based on the data strobe signal DQS.

In some situations, the data strobe signal DQS may be distorted (e.g., delayed or advanced) due to various external factors (e.g., temperature change, operating voltage change, operating rate change, etc.), resulting in the non-volatile memory device 300 not being able to normally identify the user data UD. If the user data UD is not normally identified, data not intended by the user or the program may be stored in the non-volatile memory device 300 in error.

The storage controller 200 includes a training circuitry 410. The training circuitry 410 may be implemented in the form of software, hardware, or a combination thereof. For example, in some embodiments, the training circuitry 410 may be implemented using the CPU 213 and the buffer memory 216 of FIG. 1, etc., where, for example, the buffer memory 216 stores program code for executing a training operation as discussed further herein and the CPU 213 accesses the buffer memory 216 and executes the program code to cause the CPU 213 to perform training operation as discussed below. In some embodiments, the training circuitry 410 may be implemented as an application specific integrated circuit (ASIC) or other circuit that is hard-coded to implement the training operation as discussed below.

The training circuitry 410 may perform the training operation. By the training circuitry 410 performing the training operation, the storage controller 200 may compensate for the distortion of the data strobe signal DQS and improve the reliability of data exchange with the non-volatile memory device 300 described above.

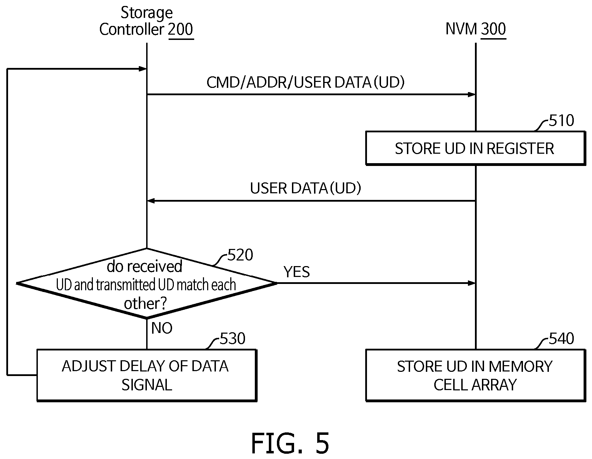

The training circuitry 410 may perform a read training operation. The read training operation may be performed during a runtime of the storage device. Various aspects of performing the reading training operation using the training circuitry 410 will be described in detail below using FIGS. 5 to 19. After receiving a request for read training, and during runtime, the storage controller 200 may determine a time point to perform the read training operation using the training circuitry 410. In some embodiments, the host connected to the storage controller 200 may determine a time point to perform the read training operation, and transmit information related to the determined time point to the storage controller 200.

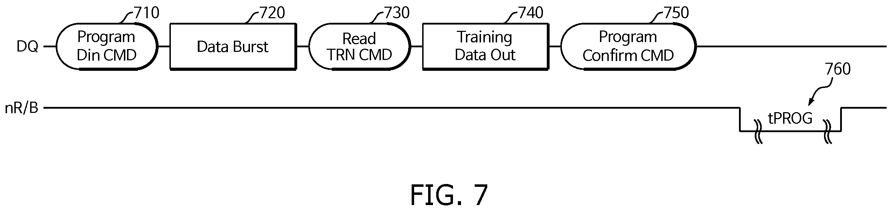

FIG. 5 is a flowchart illustrating an example in which a read training operation is performed, according to some embodiments. The storage controller 200 may transmit a data signal including a command CMD, an address ADDR, and user data UD to the non-volatile memory device 300. Each operation performed in FIG. 5 may be started and controlled based on the command CMD. Various types of the command CMD will be described below in detail with reference to FIGS. 7 to 9.

In operation 510, the non-volatile memory device 300 may store the user data UD in a register (e.g., the register 420 of FIG. 4) before storing the user data UD in a memory cell array (e.g., the memory cell array 430 of FIG. 4).

At least a part of the user data UD stored in the register of the non-volatile memory device 300 may be transmitted to the storage controller 200. If the data strobe signal DQS is not distorted, the user data UD transmitted to the storage controller 200 may be normal data.

On the other hand, if the data strobe signal DQS is distorted, the user data UD transmitted to the storage controller 200 may be abnormal data. That is, the data pattern indicating the arrangement or sequence of bits in the user data UD transmitted to the storage controller 200 may be a pattern deformed or distorted from the existing data pattern.

In operation 510, the storage controller 200 (or the training circuitry 410 of FIG. 4) may determine whether the data patterns of at least a part of the user data transmitted from the storage controller 200 and at least a part of the user data received from the register of the non-volatile memory device 300 match each other. For example, the user data transmitted from the storage controller 200 may be stored as a training pattern in the storage controller 200 (or the training circuitry 410) and used when determining whether the data patterns of the transmitted user data and the received user data match (or, correspond to) each other. In some embodiments, the size of the data transmitted from the register to the storage controller may be the same as the size of the training pattern. That is, the storage controller 200 may compare the normal user data before being transmitted to the storage controller 200 with the normal or abnormal user data (or respective data patterns) received from the register of the non-volatile memory device 300, thereby determining whether the data strobe signal DQS is normal (or distorted).

In response to determining that the transmitted and received user data do not match each other (520, NO), the storage controller 200 may adjust a delay of the data signal DQ, at 530. For example, in some embodiments, when the data patterns do not match each other, the storage controller 200 may adjust the delay. After the delay of the data signal DQ is adjusted, the previous processes 510 and 520 may be repeatedly performed on the same user data. For example, by repeatedly adjusting the delay of the data signal DQ, central alignment between the data strobe signal DQS and the data signal DQ may be completed.

In response to determining that transmitted and received user data matches each other (520, YES), the user data UD may be stored in the memory cell array of the non-volatile memory device 300, at 540. For example, in some embodiments, when the data patterns match each other, the user data UD may be stored in the memory cell array of the non-volatile memory device.

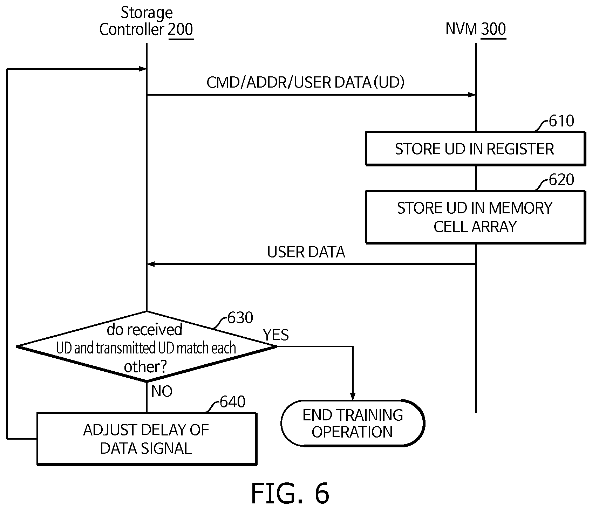

FIG. 6 is a flowchart illustrating another example in which the read training operation is performed, according to some embodiments. Unlike FIG. 5, in FIG. 6, after the user data UD is stored in the register of the non-volatile memory device 300 at 610, the user data UD may be stored in the memory cell array of the non-volatile memory device 300 at 620.

At least a part of the user data UD stored in the register of the non-volatile memory device 300 may be transmitted to the storage controller 200. The storage controller 200 (or the training circuitry 410 of FIG. 4) may determine whether at least a part of the user data transmitted from the storage controller 200 and at least a part of the user data received from the register of the non-volatile memory device 300 match each other, at 630. For example, the storage controller (or the training circuity 410 of FIG. 4) may determine whether the data patterns match each other.

In response to determining that the data do not match each other (630, NO), the storage controller 200 may adjust a delay of the data signal DQ, at 640. After the delay of the data signal DQ is adjusted, the previous operations 610 and 620 may be repeatedly performed on the same user data. In some embodiments, in response to determining that the data match each other (630, YES), the read training operation by the storage controller 200 may be terminated.

FIGS. 7 to 9 are diagrams illustrating various examples of data signals DQ transmitted and received in connection with the read training operation, according to some embodiments. The data signal DQ of FIGS. 7 to 9 represents the signals transmitted and received between a storage controller (e.g., the storage controller 200 of FIGS. 1 to 6) and a non-volatile memory device (e.g., the non-volatile memory device 300 of FIGS. 1 to 6) and may include a command CMD and user data. The ready/busy output signal nR/B may indicate the state information of the non-volatile memory device, and may be transmitted from the non-volatile memory device to the storage controller.

Referring to FIG. 7, the storage controller may transmit a program data-in command (Program Din CMD) 710 to the non-volatile memory device, and may burst transmit (Data Burst) 720 at least a part of the user data associated with the program data. At least a part of the user data may be stored in the register of the non-volatile memory device.

The storage controller may transmit a read training command (Read TRN CMD) 730 to the non-volatile memory device to initiate a read training operation. In some embodiments, the read training command 730 may be received from a host (e.g., the host 20 of FIG. 1) connected to the storage controller and transmitted to the non-volatile memory device.

In response to receiving the read training command 730 from the storage controller, the non-volatile memory device may transmit training data out 740, which is at least a part of the user data stored in the register, to the storage controller.

The storage controller may transmit a program confirmation command (Program Confirm CMD) 750 to the non-volatile memory device, in response to determining that at least a part of the user data (e.g., training pattern) and the data (training data) received from the non-volatile memory device correspond to or match each other.

In response to receiving the program confirmation command 750 from the storage controller, the non-volatile memory device stores the user data stored in the register in the memory cell array. For example, during a program time tPROG 760, the user data stored in the register may be stored in the memory cell array of the non-volatile memory device, and the non-volatile memory device may transmit the ready/busy output signal nR/B indicating a busy state to the storage controller.

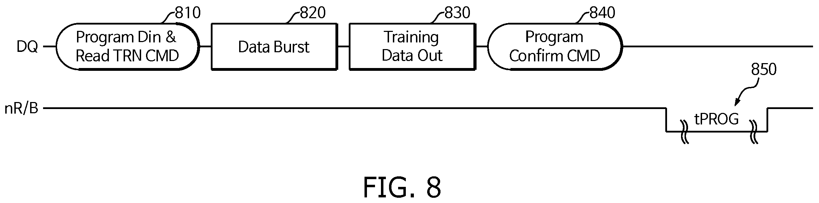

Referring to FIG. 8, the program data-in command (Program Din CMD) 710 and the read training command 730 of FIG. 7 may be transmitted to the non-volatile memory device as one command 810. In response to the storage controller completing a burst transmission 820 of at least a part of the user data, the non-volatile memory device may transmit (830) the training data out to the storage controller.

In response to receiving a program confirmation command 840 from the storage controller, the non-volatile memory device stores the user data stored in the register during a program time tPROG 850 in the memory cell array of the non-volatile memory device.

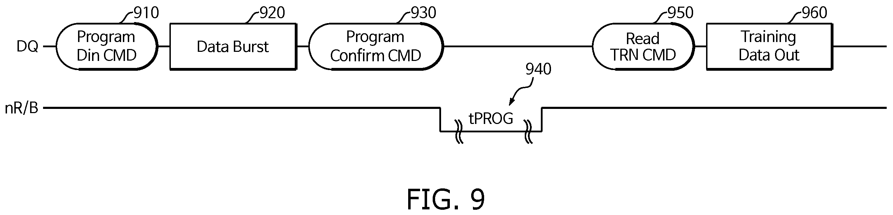

Referring to FIG. 9, a program data-in command 910 and a burst transmission 920 may be transmitted from the storage controller to the non-volatile memory device. In response to the non-volatile memory device receiving the user data and a program confirm command 930 from the storage controller, the user data may be stored in the memory cell array during a program time tPROG 940, and a read training command 950 may be transmitted to the non-volatile memory device.

Embodiments are not limited thereto, and the read training command 950 may be transmitted to the non-volatile memory device at any time after the storage controller completes the burst transmission 920 of at least the part of the user data. The non-volatile memory device may transmit the training data to the storage controller at 960 in response to receiving the read training command 950.

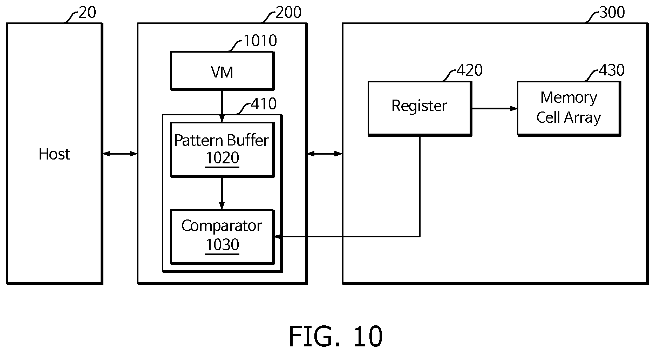

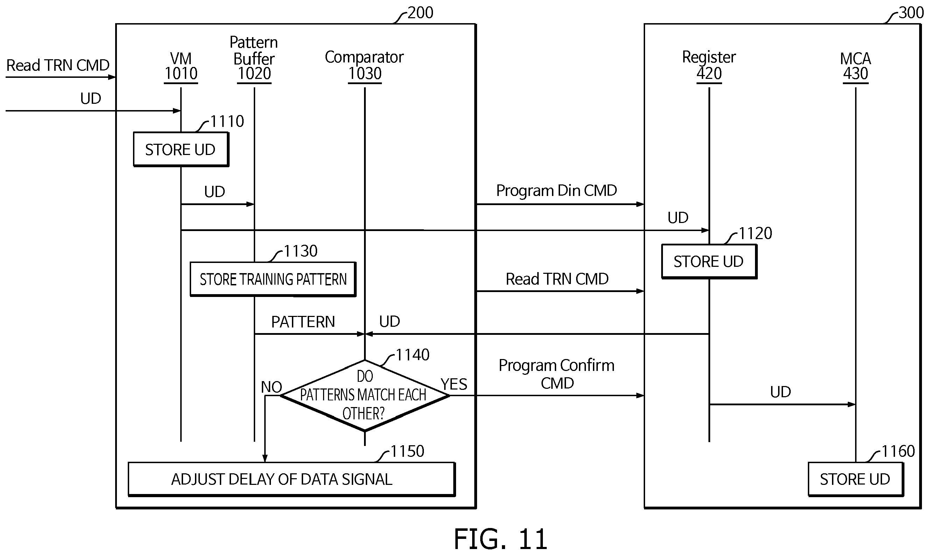

FIG. 10 is a block diagram illustrating, in more detail, a configuration of the storage controller 200 for performing the read training operation, according to some embodiments. The storage controller 200 may include a volatile memory (VM) 1010 and the training circuitry 410. The training circuitry 410 includes a pattern buffer 1020 and a comparator 1030. Details of the operations performed using each of the configurations illustrated in FIG. 10 will be described in detail with reference to FIGS. 11 to 13.

FIGS. 11 to 13 are diagrams illustrating various examples in which the read training operation is performed using the storage controller 200 and the non-volatile memory device 300 of FIG. 10, according to some embodiments. The training operation may be performed in response to receiving a request for training (e.g., read training command (Read TRN CMD)) from the host. For example, the training operation may be performed in response to training circuitry including the pattern buffer 1020 and the comparator 1030 receiving a request for read training from the host.

Referring to FIG. 11, the storage controller 200 may receive the read training command (Read TRN CMD) from the host. In some embodiments, the storage controller 200 may receive user data UD from the host. The storage controller 200 may store the received user data UD in the volatile memory 1010, at 1110.

The storage controller 200 may transmit the program data-in command (Program Din CMD) and the user data UD to the non-volatile memory device 300. In response to receiving the program data-in command (Program Din CMD), the non-volatile memory device 300 may store the received user data UD in the register 420, at 1120.

The storage controller 200 stores at least a part of the user data UD in the pattern buffer 1020 as a training pattern, at 1130. For example, in response to receiving the read training command (Read TRN CMD) from the host, the storage controller 200 may store the training pattern in the pattern buffer 1020. The storage controller 200 may store the training pattern in the pattern buffer 1020 before, after, or at the same time the user data (UD) is stored in the register 420.

The storage controller 200 may transmit the training pattern stored in the pattern buffer 1020 to the comparator 1030, and the non-volatile memory device 300 may transmit at least a part of the user data stored in the register 420 to the comparator 1030. For example, in response to receiving the read training command (Read TRN CMD), the non-volatile memory device 300 may transmit at least the part of the user data stored in the register 420 to the comparator 1030. The data transmitted from the register 420 to the comparator 1030 and the training pattern transmitted from the pattern buffer 1020 to the comparator 1030 may be corresponding data that has the same size as each other.

The comparator 1030 compares (or, determines) whether the training pattern received from the pattern buffer 1020 and at least the part of the user data received from the register 420 match (or, correspond to) each other, at 1140.

In response to determining that at least the part of the training pattern and the user data received from the register 420 do not match each other (1140, NO), the storage controller 200 may adjust the delay of the data signal, at 1150. For example, as the delay of the data signal is repeatedly adjusted, the central alignment between the data strobe signal and the data signal may be completed, and the read training operation may be completed.

In response to determining that the at least the part of the training pattern and the user data received from the register 420 match each other (1140, YES), the storage controller 200 may transmit the program confirmation command (Program Confirm CMD) to the non-volatile memory device 300. In response to receiving the program confirmation command, the non-volatile memory device 300 may store the user data stored in the register 420 in the memory cell array 430, at 1160.

As illustrated and described above, according to various embodiments, the read training operation of the storage device is performed using at least the part of the user data, instead of using separately generated data for the read training operation. Through this configuration, according to various embodiments, the read training may be performed without a data-in operation of data separately generated for read training operation, thereby shortening time required for the read training. According to various embodiments, the read training operation may be performed even during runtime of the non-volatile memory device 300.

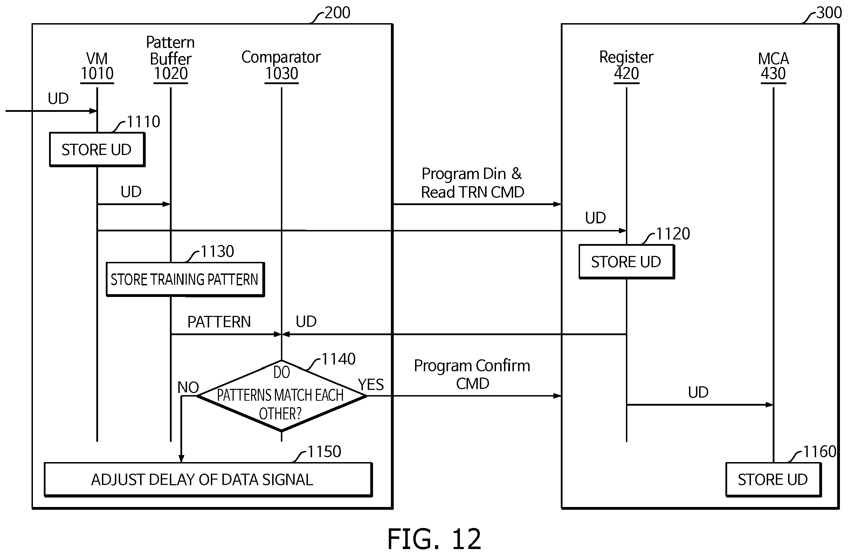

Referring to FIG. 12, unlike FIG. 11, the program data-in command (Program Din CMD) and the read training command (Read TRN CMD) may be transmitted to the non-volatile memory device 300 as one command.

In FIG. 11, at least the part of the user data stored in the register 420 may be transmitted to the comparator 1030 in response to the non-volatile memory device 300 receiving the read training command (Read TRN CMD), whereas in FIG. 12, at least the part of the user data stored in the register 420 may be transmitted to the comparator 1030 in response to the completion of the user data storage operation 1120. Through this configuration, compared to when the read training command (Read TRN CMD) is transmitted to the non-volatile memory device 300 as a separate command, the time for the read training operation may be further shortened.

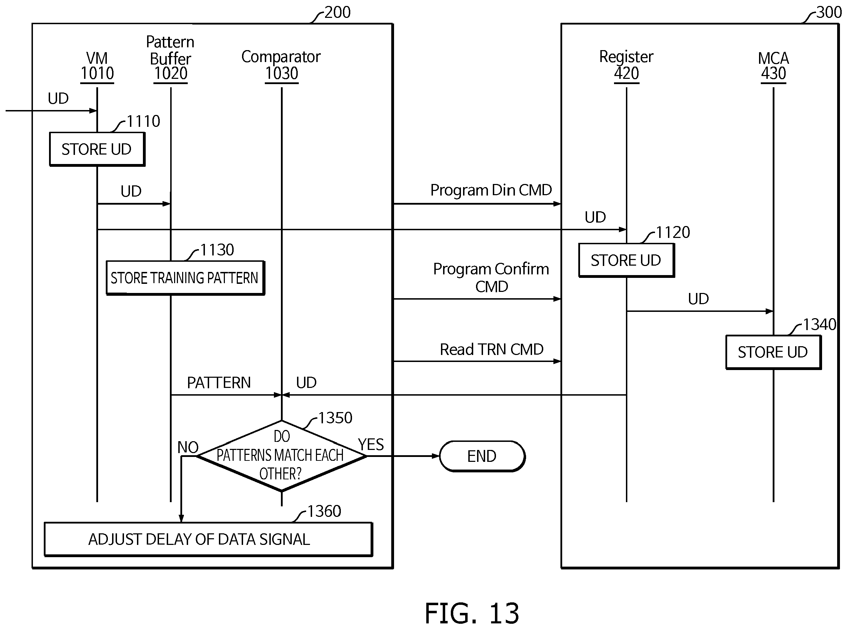

Referring to FIG. 13, unlike FIG. 11, the non-volatile memory device 300 may receive the read training command (Read TRN CMD) after receiving the program confirm command (Program Confirm CMD) from the storage controller 200. In response to receiving the program confirm command (Program Confirm CMD) from the storage controller 200, the non-volatile memory device 300 may store the user data (UD) in the memory cell array 430, at 1340.

The read training command (Read TRN CMD) may be transmitted to the non-volatile memory device 300 at any time after the user data UD is transmitted from the volatile memory 1010 to the non-volatile memory device 300.

In response to receiving the read training command (Read TRN CMD) from the storage controller 200, the non-volatile memory device 300 may transmit at least the part of the data stored in the register 420 to the comparator 1030.

The comparator 1030 may compare (or, determine) whether the training pattern and the pattern of at least the part of the user data match (or, correspond to) each other, at 1350. In response to the comparator 1030 determining that the training pattern and at least the part of the user data received from the register 420 do not match each other (1350, NO), the storage controller 200 may adjust the delay of the data signal, at 1360.

In some embodiments, in response to the comparator 1030 determining that the training pattern and at least the part of user data match each other (1350, YES), the training operation by the storage controller 200 may be terminated.

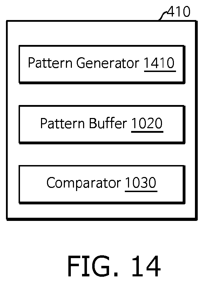

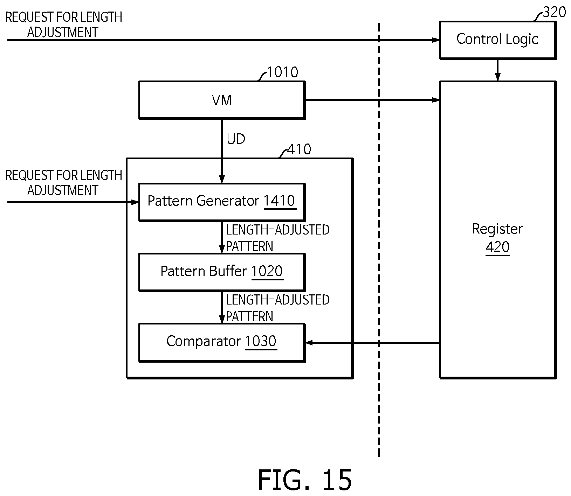

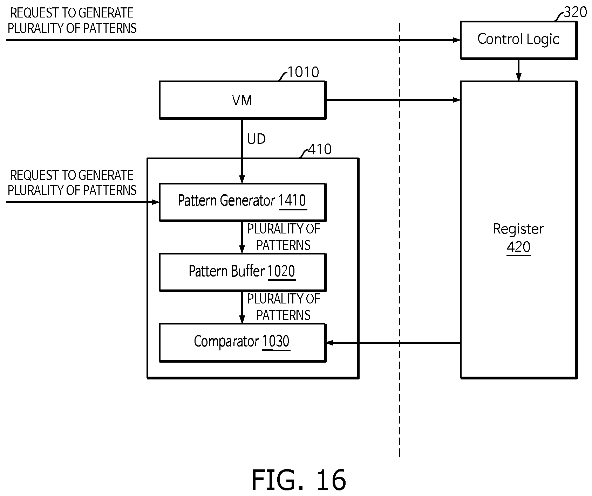

FIG. 14 is a block diagram illustrating an example of the training circuitry 410 including a pattern generator 1410, according to some embodiments. The pattern generator 1410 generates a training pattern to be stored in the pattern buffer 1020 based on the user data. The pattern generator 1410 may adjust the length of the training pattern or generate a plurality of training patterns. This configuration and operation will be described below with reference to FIGS. 15 and 16, respectively.

FIG. 15 is a block diagram illustrating an example in which a training pattern adjusted in length is generated using the pattern generator 1410, according to some embodiments. The pattern generator 1410 may receive a request to adjust the length of the training pattern. In some embodiments, the request to adjust the length of the training pattern may be received from the host. In some embodiments, the storage controller may generate a request to adjust the length of the training pattern.

In response to receiving the request to adjust the length of the training pattern, the pattern generator 1410 may adjust the size of the data (e.g., training pattern) stored in the pattern buffer 1020.

In some embodiments, in response to receiving the request to adjust the length of the training pattern, the size of the data transmitted from the register 420 to the comparator 1030 may be adjusted. In some embodiments, the size of the data transmitted from the register 420 to the comparator 1030 may be adjusted by the control logic 320, in response to the control logic 320 receiving the request for length adjustment, so that the data (e.g., training pattern) stored in the pattern buffer 1020 and the data transmitted from the register 420 to the comparator 1030 have the same size.

The length-adjusted training pattern may be transmitted from the pattern buffer 1020 to the comparator 1030, and the data, of the data stored in the register 420, that corresponds to the length-adjusted pattern may be transmitted to the comparator 1030. The comparator 1030 may compare the length-adjusted training pattern and the data received from the register 420 to determine whether or not to adjust the delay of the data signal.

FIG. 16 is a block diagram illustrating an example in which a plurality of training patterns are generated using the pattern generator 1410, according to some embodiments. The pattern generator 1410 may receive a request to generate a plurality of patterns. In some embodiments, the request to generate the plurality of patterns may be received from the host. In some embodiments, the storage controller may generate a request to adjust the length of the training pattern.

In response to receiving the request to generate the plurality of patterns, the pattern generator 1410 may generate a plurality of training patterns to be stored in the pattern buffer 1020. For example, the pattern generator 1410 may divide the user data UD into divided user data UD_1 to UD_n and generate a plurality of training patterns using the divided user data UD_1 to UD_n. At least some of the plurality of training patterns generated by the pattern generator 1410 have different lengths from each other. In some embodiments, the control logic 320 may receive the request to generate the plurality of patterns. In response to receiving the request to generate the plurality of patterns, the control logic 320 may control the register 420 so that the register 420 transmits plurality of patterns to the comparator 1030, and each of the plurality of patterns stored in the pattern buffer 1020 and the each of the plurality of patterns transmitted from the register 420 to the comparator 1030 correspond to each other and have the same size.

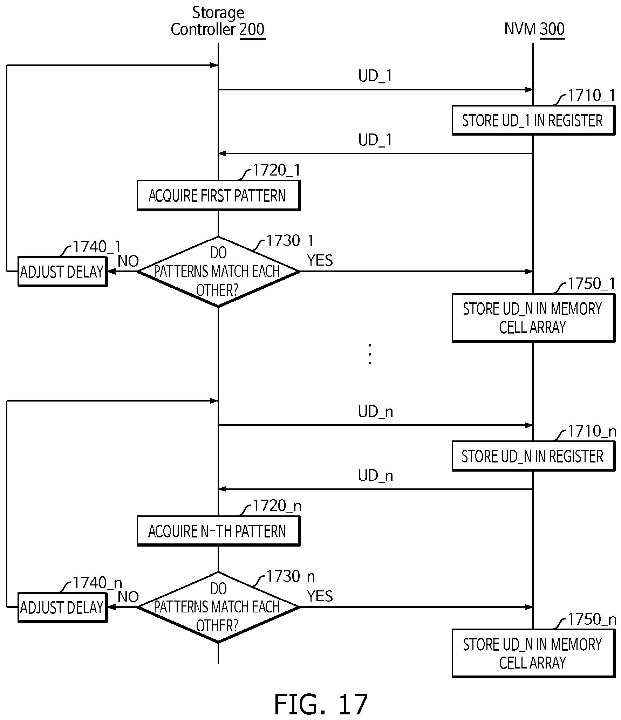

The training circuitry 410 may perform a plurality of read training operations using each of the plurality of training patterns. This operation and configuration will be described below in detail with reference to FIG. 17.

FIG. 17 is a flowchart illustrating an example in which a plurality of read training operations are performed using the pattern generator 1410 of FIG. 16, according to some embodiments. The first to n-th user data UD_1 to UD_n (where, n is a natural number of 2 or more) may be data generated by the storage controller 200 dividing the user data UD. The pattern generator of the storage controller 200 may generate a plurality of training patterns based on the first to n-th user data UD_1 to UD_n and store the plurality of training patterns in the pattern buffer.

The storage controller 200 may transmit the first user data UD_1 to the non-volatile memory device 300. The non-volatile memory device 300 may store the first user data UD_1 in a register (e.g., the register 420 of FIG. 16), at 1710_1.

The non-volatile memory device 300 may transmit at least a part of the first user data UD_1 stored in the register to the storage controller 200 (or to the comparator 1030 of FIG. 16).

The comparator of the storage controller 200 may acquire the first training pattern stored in the pattern buffer, at 1720_1, and determine whether the first training pattern and at least the part of the first user data UD_1 match each other, at 1730_1.

In response to determining that the data patterns do not match each other (1730_1, NO), the storage controller 200 may adjust the delay of the data signal, at 1740_1. After the delay of the data signal is adjusted, the previous processes 1710_1, 1720_1, and 1730_1 may be repeatedly performed on the same first user data UD_1. In response to determining that the data patterns match each other (1730_1, YES), the first user data UD_1 may be stored in the memory cell array of the non-volatile memory device 300, at 1750_1.

The process described above may be repeated a number of times corresponding to the number of the plurality of training patterns generated based on user data.

For example, the storage controller 200 may transmit the n-th user data UD_n to the non-volatile memory device 300 (where, n is a natural number greater than or equal to 2). The non-volatile memory device 300 may store the n-th user data UD_n in the register (e.g., the register 420 of FIG. 16), at 1710_n.

At least a part of the n-th user data UD_n stored in the register of the non-volatile memory device 300 may be transmitted to the storage controller 200 (or to the comparator 1030 of FIG. 16).

The comparator of the storage controller 200 may acquire the n-th user data (UD_n) stored in the pattern buffer, at 1720_n, and determine whether the n-th training pattern and at least a part of the n-th user data (UD_n) match each other, at 1730_n.

In response to determining that the data patterns do not match each other (1730_n, NO), the storage controller 200 may adjust the delay of the data signal, at 1740_n. After the delay of the data signal is adjusted, the previous processes (1710_n, 1720_n, 1730_n) may be repeatedly performed with respect to the same n-th user data (UD_n). In response to determining that the data patterns match each other (1730_n, YES), the n-th user data UD_n may be stored in the memory cell array of the non-volatile memory device 300, at 1750_n.

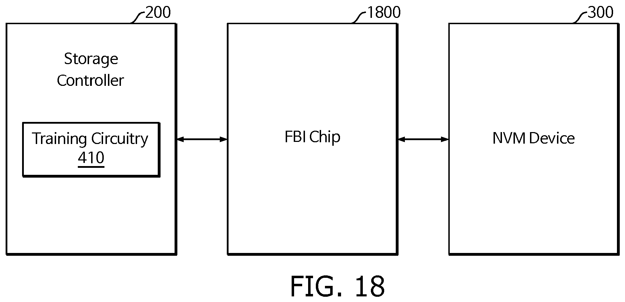

FIG. 18 is a block diagram illustrating a storage device including a frequency boosting interface (FBI) chip 1800, according to some embodiments.

Referring to FIG. 18, the storage device may further include the FBI chip 1800. The FBI chip 1800 may be disposed between the storage controller 200 and the non-volatile memory device 300 to receive data from the storage controller 200 and transmit the data to the non-volatile memory device 300, and may receive data from the non-volatile memory device 300 and transmit the data to the storage controller 200. Although FIG. 18 illustrates only one non-volatile memory device 300, in some embodiments, a plurality of non-volatile memory devices 300 that communicate data with the FBI chip 1800 may be implemented.

Unlike the embodiment illustrated in FIG. 18, in some embodiments, the training circuitry 410 may be disposed in the FBI chip 1800. In this case, by preemptively performing read training in the training circuitry 410 disposed in the FBI chip 1800 using the pattern of user data programmed in the non-volatile memory device 300, errors may be quickly identified compared to when performing the read training in the storage controller 200.

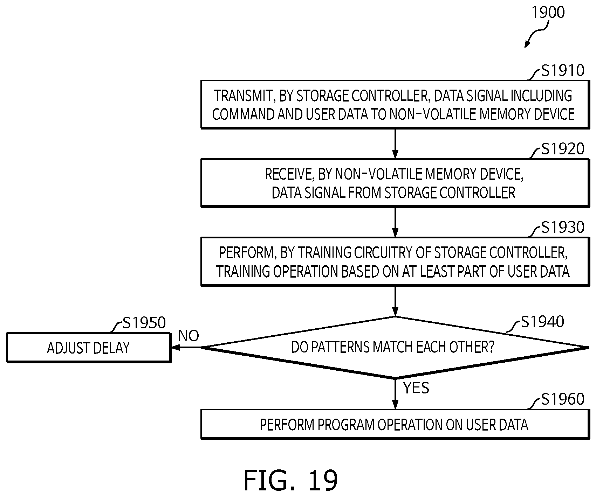

FIG. 19 is a flowchart illustrating an operating method 1900 of a storage device, according to some embodiments. The method 1900 may be performed by a storage device including a storage controller and a non-volatile memory device, and the storage controller may include training circuitry.

The method 1900 may be initiated by the storage controller transmitting a data signal including a command and user data to a non-volatile memory device, at S1910. The non-volatile memory device may receive the data signal from the storage controller, at S1920.

The training circuitry of the storage controller may perform a training operation based on at least a part of the user data, at S1930. For example, the storage controller may transmit a read training command (Read TRN CMD) to the non-volatile memory device to initiate a read training operation.

The storage controller (or comparator) may determine whether the training pattern, which is at least the part of the user data, and at least a part of the user data received by the non-volatile memory device from the storage controller match each other, at S1940.

In response to determining that the data patterns do not match each other (S1940, NO), the storage controller may adjust the delay of the data signal, at S1950.

In some embodiments, in response to determining that the data patterns match each other (S1940, YES), the storage controller may perform a program operation on the user data, at S1960.

The flowchart and description described above with reference to FIG. 19 are merely examples and may be implemented differently in some aspects. For example, in some examples, the order of respective operations may be changed, some of the operations may be repeatedly performed, some may be omitted, or some may be added. For example, although the operations at S1940 to S1960 are illustrated as separate from S1930, in some embodiments, the operations at S1940 to S1960 may be included in S1930.

While various embodiments have been described in connection with the accompanying drawings, it is to be understood that the disclosure is not limited to the various embodiments, but, on the contrary, is intended to cover various modifications and equivalent arrangements included within the scope of the appended claims.

## Claims

1. A storage device (100) comprising:
a storage controller (200) that comprises training circuitry (410) and that transmits a data signal comprising a command and user data; and
a non-volatile memory device (300), comprising a register (420), that receives the data signal from the storage controller (200), wherein the training circuitry (410) is configured to perform a read training operation based on at least a part of the user data;
wherein:
the training circuitry (410) comprises a pattern buffer (1020), and
the storage controller (200) is configured to store in the pattern buffer (1020), as a training pattern, the at least part of the user data,
the training circuitry (410) further comprises a comparator (1030),
the non-volatile memory device (300) is configured to store, in the register (420), the user data received from the storage controller (200),
the non-volatile memory device (300) is configured to transmit to the comparator (1030), at least part of the user data stored in the register (420), and
the comparator (1030) is configured to compare the training pattern stored in the pattern buffer (1020) with the at least the part of the user data received from the register (420);
wherein the non-volatile memory device (300) further comprises a memory cell array (430), and
the non-volatile memory device (300) is configured to store, in the memory cell array (430), the user data stored in the register (420); and
wherein based on the comparator (1030) determining that the training pattern stored in the pattern buffer (1020) matches the at least part of the user data received from the register (420), the storage controller (200) is configured to transmit a program confirmation command to the non-volatile memory device (300), and
based on receiving the program confirmation command from the storage controller (200), the non-volatile memory device (300) is configured to store in the memory cell array (430) the user data that is stored in the register (420); and
**characterised in that**:
the training circuitry (410) comprises a pattern generator, and
the pattern generator is configured to generate a plurality of training patterns based on the user data, and
at least some of the plurality of training patterns have different lengths from each other.

2. The storage device according to claim 1, wherein, based on receiving a read training command from the storage controller (200), the non-volatile memory device (300) is configured to transmit to the comparator (1030) the at least part of the user data stored in the register (420).

3. The storage device according to claim 1 or 2, wherein a size of the at least part of the user data transmitted from the register (420) to the comparator (1030) is the same as a size of the training pattern stored in the pattern buffer (1020).

4. The storage device according to any preceding claim, wherein:
the non-volatile memory device (300) is configured to store the user data in the memory cell array (430) during a runtime of the storage device.

5. The storage device according to any one of claims 1 to 3, wherein:
after the non-volatile memory device (300) stores the user data stored in the register (420) in the memory cell array (430), the comparator (1030) is configured to determine whether the training pattern and the at least the part of the user data received from the register (420) correspond to each other.

6. The storage device according to any one of claims 1 to 5, wherein, based on the comparator (1030) determining that the training pattern and the at least part of the user data received from the register (420) do not correspond to each other, the storage controller (200) is configured to adjust a delay of the data signal.

7. The storage device according to any one of claims 1 to 6, wherein:
based on receiving a request to adjust a length of the training pattern, a size of the at least part of the user data stored in the pattern buffer (1020) and a size of the at least part of the user data transmitted from the register (420) to the comparator (1030) are adjusted, and
the request to adjust the length of the training pattern is received from a host (20).

8. The storage device according to any preceding claim, wherein:
the training circuitry (410) is configured to perform the read training operation, based on receiving a read training request from a host (20), and
after receiving the read training request, the storage controller (200) is configured to determine a time point during runtime to perform the read training operation.

9. The storage device according to any preceding claim, wherein the command comprises a program data-in command and a read training command.

10. A method for operating a storage device according to any preceding claim, the method comprising:
transmitting, by a storage controller (200), a data signal comprising a command and user data to a non-volatile memory device (300);
receiving, by the non-volatile memory device (300), the data signal from the storage controller (200); and
performing, by a training unit of the storage controller (200), a training operation based on at least a part of the user data.

## Patentansprüche

1. Speicherungsvorrichtung (100), umfassend:
eine Speicherungssteuereinheit (200), die eine Trainingsschaltung (410) umfasst und ein Datensignal umfassend einen Befehl und Benutzerdaten überträgt; und
eine nichtflüchtige Speichervorrichtung (300), umfassend ein Register (420), das das Datensignal von der Speicherungssteuereinheit (200) empfängt, wobei die Trainingsschaltung (410) konfiguriert ist, um eine Lesetrainingsoperation auf der Grundlage mindestens eines Teils der Benutzerdaten durchzuführen;
wobei:
die Trainingsschaltung (410) einen Musterpuffer (1020) umfasst, und
die Speicherungssteuereinheit (200) konfiguriert ist, um den mindestens einen Teil der Benutzerdaten als Trainingsmuster in dem Musterpuffer (1020) zu speichern,
die Trainingsschaltung (410) weiter einen Komparator (1030) umfasst,
die nichtflüchtige Speichervorrichtung (300) so konfiguriert ist, um die von der Speicherungssteuereinheit (200) empfangenen Benutzerdaten in dem Register (420) zu speichern,
der nichtflüchtige Speichervorrichtung (300) konfiguriert ist, um mindestens einen Teil der in dem Register (420) gespeicherten Benutzerdaten an den Komparator (1030) zu übertragen, und
der Komparator (1030) konfiguriert ist, um das in dem Musterpuffer (1020) gespeicherte Trainingsmuster mit dem mindestens einen Teil der aus dem Register (420) empfangenen Benutzerdaten zu vergleichen;
wobei die nichtflüchtige Speichervorrichtung (300) weiter ein Speicherzellenarray (430) umfasst, und
die nichtflüchtige Speichervorrichtung (300) konfiguriert ist, um die in dem Register (420) gespeicherten Benutzerdaten in dem Speicherzellenarray (430) zu speichern; und
wobei, basierend darauf, dass der Komparator (1030) bestimmt, dass das in dem Musterpuffer (1020) gespeicherte Trainingsmuster mit dem mindestens einen Teil der aus dem Register (420) empfangenen Benutzerdaten übereinstimmt, die Speicherungssteuereinheit (200) konfiguriert ist, um einen Programmbestätigungsbefehl an die nichtflüchtige Speichervorrichtung (300) zu übertragen, und
basierend auf dem Empfangen des Programmbestätigungsbefehls aus der Speicherungssteuereinheit (200) die nichtflüchtige Speichervorrichtung (300) konfiguriert ist, um die in dem Register (420) gespeicherten Benutzerdaten in dem Speicherzellenarray (430) zu speichern; und
**dadurch gekennzeichnet, dass**:
die Trainingsschaltung (410) einen Mustergenerator umfasst, und
der Mustergenerator konfiguriert ist, um auf Basis der Benutzerdaten eine Vielzahl von Trainingsmustern zu erzeugen, und
mindestens einige der Vielzahl von Trainingsmustern voneinander unterschiedliche Längen aufweisen.

2. Speicherungsvorrichtung nach Anspruch 1, wobei, basierend auf dem Empfangen eines Lesetrainingsbefehls aus der Speicherungssteuereinheit (200) die nichtflüchtige Speichervorrichtung (300) konfiguriert ist, um den mindestens einen Teil der in dem Register (420) gespeicherten Benutzerdaten an den Komparator (1030) zu übertragen.

3. Speicherungsvorrichtung nach Anspruch 1 oder 2, wobei eine Größe des mindestens einen Teils der aus dem Register (420) an den Komparator (1030) übertragenen Benutzerdaten gleich einer Größe des in dem Musterpuffer (1020) gespeicherten Trainingsmusters ist.

4. Speicherungsvorrichtung nach einem vorstehenden Anspruch, wobei:
die nichtflüchtige Speichervorrichtung (300) konfiguriert ist, um die Benutzerdaten während einer Laufzeit der Speicherungsvorrichtung in dem Speicherzellenarray (430) zu speichern.

5. Speicherungsvorrichtung nach einem der Ansprüche 1 bis 3, wobei:
nachdem die nichtflüchtige Speichervorrichtung (300) die in dem Register (420) gespeicherten Benutzerdaten in dem Speicherzellenarray (430) gespeichert hat, der Komparator (1030) konfiguriert ist, um zu bestimmen, ob das Trainingsmuster und der mindestens eine Teil der aus dem Register (420) empfangenen Benutzerdaten miteinander übereinstimmen.

6. Speicherungsvorrichtung nach einem der Ansprüche 1 bis 5, wobei, basierend darauf, dass der Komparator (1030) bestimmt, dass das Trainingsmuster und der mindestens eine Teil der aus dem Register (420) empfangenen Benutzerdaten nicht miteinander übereinstimmen, die Speicherungssteuereinheit (200) konfiguriert ist, um eine Verzögerung des Datensignals anzupassen.

7. Speicherungsvorrichtung nach einem der Ansprüche 1 bis 6, wobei:
basierend auf dem Empfangen einer Anfrage zur Anpassung einer Länge des Trainingsmusters eine Größe des mindestens eines Teils der in dem Musterpuffer (1020) gespeicherten Benutzerdaten und eine Größe des mindestens eines Teils der aus Register (420) an den Komparator (1030) übertragenen Benutzerdaten angepasst werden, und
die Anfrage zur Anpassung der Länge des Trainingsmusters aus einem Host (20) empfangen wird.

8. Speicherungsvorrichtung nach einem vorstehenden Anspruch, wobei:
die Trainingsschaltung (410) konfiguriert ist, um die Lesetrainingsoperation basierend auf dem Empfangen einer Lesetrainingsanforderung aus einem Host (20) durchzuführen, und
nach dem Empfangen der Lesetrainingsanforderung die Speicherungssteuereinheit (200) konfiguriert ist, um einen Zeitpunkt während der Laufzeit zu bestimmen, zu dem die Lesetrainingsoperation durchgeführt werden soll.

9. Speicherungsvorrichtung nach einem vorstehenden Anspruch, wobei der Befehl einen Programmdaten-Eingabebefehl und einen Lesetrainingsbefehl umfasst.

10. Verfahren zum Betreiben einer Speicherungsvorrichtung nach einem vorstehenden Anspruch, wobei das Verfahren Folgendes umfasst:
Übertragen, durch eine Speicherungssteuereinheit (200), eines Datensignals, das einen Befehl und Benutzerdaten umfasst, an eine nichtflüchtige Speichervorrichtung (300);
Empfangen, durch die nichtflüchtige Speichervorrichtung (300), des Datensignals aus der Speicherungssteuereinheit (200); und
Durchführen, durch eine Trainingseinheit der Speicherungssteuereinheit (200), einer Trainingsoperation basierend auf mindestens einem Teil der Benutzerdaten.

## Revendications

1. Dispositif de stockage (100) comprenant :
un dispositif de commande de stockage (200) qui comprend un circuit d'entraînement (410) et qui transmet un signal de données comprenant une commande et des données utilisateur ; et
un dispositif de mémoire non volatile (300), comprenant un registre (420), qui reçoit le signal de données à partir du dispositif de commande de stockage (200), dans lequel le circuit d'entraînement (410) est configuré pour réaliser une opération d'entraînement de lecture sur la base d'au moins une partie des données utilisateur ;
dans lequel :
le circuit d'entraînement (410) comprend un tampon de modèles (1020), et
le dispositif de commande de stockage (200) est configuré pour stocker dans le tampon de modèles (1020), en tant que modèle d'entraînement, la au moins une partie des données utilisateur,
le circuit d'entraînement (410) comprend en outre un comparateur (1030),
le dispositif de mémoire non volatile (300) est configuré pour stocker, dans le registre (420), les données utilisateur reçues à partir du dispositif de commande de stockage (200),
le dispositif de mémoire non volatile (300) est configuré pour transmettre au comparateur (1030) au moins une partie des données utilisateur stockées dans le registre (420), et
le comparateur (1030) est configuré pour comparer le modèle d'entraînement stocké dans le tampon de modèles (1020) avec la au moins une partie des données utilisateur reçues à partir du registre (420) ;
dans lequel le dispositif de mémoire non volatile (300) comprend en outre un réseau de cellules de mémoire (430), et
le dispositif de mémoire non volatile (300) est configuré pour stocker, dans le réseau de cellules de mémoire (430), les données utilisateur stockées dans le registre (420) ; et
dans lequel, sur la base du comparateur (1030) déterminant que le modèle d'entraînement stocké dans le tampon de modèles (1020) coïncide avec la au moins une partie des données utilisateur reçues à partir du registre (420), le dispositif de commande de stockage (200) est configuré pour transmettre une commande de confirmation de programme au dispositif de mémoire non volatile (300), et
sur la base de la réception de la commande de confirmation de programme à partir du dispositif de commande de stockage (200), le dispositif de mémoire non volatile (300) est configuré pour stocker dans le réseau de cellules de mémoire (430) les données utilisateur qui sont stockées dans le registre (420) ; et
**caractérisé en ce que** :
le circuit d'entraînement (410) comprend un générateur de modèles, et
le générateur de modèles est configuré pour générer une pluralité de modèles d'entraînement sur la base des données utilisateur, et
au moins certains de la pluralité de modèles d'entraînement présentent des longueurs différentes les unes des autres.

2. Dispositif de stockage selon la revendication 1, dans lequel, sur la base de la réception d'une commande d'entraînement de lecture à partir du dispositif de commande de stockage (200), le dispositif de mémoire non volatile (300) est configuré pour transmettre au comparateur (1030) la au moins une partie des données utilisateur stockées dans le registre (420).

3. Dispositif de stockage selon la revendication 1 ou 2, dans lequel une taille de la au moins une partie des données utilisateur transmises à partir du registre (420) au comparateur (1030) est la même qu'une taille du modèle d'entraînement stocké dans la mémoire tampon de modèles (1020).

4. Dispositif de stockage selon une quelconque revendication précédente, dans lequel :
le dispositif de mémoire non volatile (300) est configuré pour stocker les données utilisateur dans le réseau de cellules de mémoire (430) pendant une durée d'exécution du dispositif de stockage.

5. Dispositif de stockage selon l'une quelconque des revendications 1 à 3, dans lequel :
après que le dispositif de mémoire non volatile (300) a stocké les données utilisateur stockées dans le registre (420) dans le réseau de cellules de mémoire (430), le comparateur (1030) est configuré pour déterminer si le modèle d'entraînement et la au moins une partie des données utilisateur reçues à partir du registre (420) correspondent l'un à l'autre.

6. Dispositif de stockage selon l'une quelconque des revendications 1 à 5, dans lequel, sur la base du comparateur (1030) déterminant que le modèle d'entraînement et la au moins une partie des données utilisateur reçues à partir du registre (420) ne correspondent pas l'un à l'autre, le dispositif de commande de stockage (200) est configuré pour ajuster un délai du signal de données.

7. Dispositif de stockage selon l'une quelconque des revendications 1 à 6, dans lequel :
sur la base de la réception d'une demande d'ajustement d'une longueur du modèle d'entraînement, une taille de la au moins une partie des données utilisateur stockées dans le tampon de modèles (1020) et une taille de la au moins une partie des données utilisateur transmises à partir du registre (420) au comparateur (1030) sont ajustées, et
la demande d'ajustement de la longueur du modèle d'entraînement est reçue à partir d'un hôte (20).

8. Dispositif de stockage selon une quelconque revendication précédente, dans lequel :
le circuit d'entraînement (410) est configuré pour réaliser l'opération d'entraînement de lecture, sur la base de la réception d'une demande d'entraînement de lecture à partir d'un hôte (20), et
après avoir reçu la demande d'entraînement de lecture, le dispositif de commande de stockage (200) est configuré pour déterminer un point dans le temps pendant la durée d'exécution pour réaliser l'opération d'entraînement de lecture.

9. Dispositif de stockage selon une quelconque revendication précédente, dans lequel la commande comprend une commande d'entrée de données de programme et une commande d'entraînement de lecture.

10. Procédé de fonctionnement d'un dispositif de stockage selon une quelconque revendication précédente, le procédé comprenant :
la transmission, par un dispositif de commande de stockage (200), d'un signal de données comprenant une commande et des données utilisateur à un dispositif de mémoire non volatile (300) ;
la réception, par le dispositif de mémoire non volatile (300), du signal de données à partir du dispositif de commande de stockage (200) ; et
la réalisation, par une unité d'entraînement du dispositif de commande de stockage (200), d'une opération d'entraînement sur la base d'au moins une partie des données utilisateur.
